# EUROPEAN PATENT APPLICATION

(11) **EP 1 710 661 A1**
(43) Date of publication of application: **11.10.2006**
(21) Application number: 04807840.6
(22) Date of filing: 20.12.2004
(51) Int. Cl.: G06F 1/24, G06F 11/30

(54) **MONITORING CIRCUIT**

(30) Priority: 26.12.2003 JP 2003432797; 30.09.2004 JP 2004285617
(71) Applicant: ROHM CO., LTD., Kyoto-shi, Kyoto 615-8585 (JP)
(72) Inventor: NISHIKAWA, Nobuhiro, c/o Rohm Co., Ltd., Kyoto-shi, Kyoto 6158585 (JP); INOUE, Hiroki, c/o Rohm Co., Ltd., Kyoto-shi, Kyoto 6158585 (JP)
(74) Representative: TBK-Patent
(86) International application number: PCT/JP2004/019485
(87) International publication number: WO 2005/066742

(57) **Abstract**

A monitoring circuit for preventing a malfunction of a microcomputer including a capacitor, charging means for charging the capacitor, discharging means for discharging the capacitor, voltage comparing means for comparing a certain reference voltage with a charging voltage of the capacitor, thereby generating a signal for resetting an operation of a monitoring object when the capacitor is charged to have a certain voltage or more, and source voltage deciding means for monitoring a source voltage of the monitoring object and resetting the operation of the monitoring object when the source voltage of the monitoring object is equal to or lower than a certain voltage.

## Description

### <TECHNICAL FIELD>

The present invention relates to a monitoring circuit to be an effective technique utilizing a fail-safe system for detecting an abnormal operation of a microcomputer to automatically take avoiding measures.

### <BACKGROUND ART>

For a method of monitoring whether a microcomputer is operated normally or not, a method of deciding the presence of an arrival of a normal operation clock from the microcomputer to carry out monitoring by a monitoring circuit is generally executed. Such a method has been disclosed in JP-A-2003-172762.

### <DISCLOSURE OF THE INVENTION>

In such a method, however, also when a voltage to be supplied to the microcomputer is decreased, the monitoring circuit can detect that the microcomputer is not normally operated by only monitoring the normal operation clock from the microcomputer for a certain time. For this reason, when a power to be supplied to the microcomputer is decreased, it is impossible to safely reset the microcomputer immediately. Even if the microcomputer recovers the operation when a power supply is returned from a power decreasing state to a stable state, therefore, there is a possibility that the microcomputer might malfunction due to a memory or a register which is provided in the microcomputer which interrupts an operation by a decrease in a power.

In consideration of the conventional actual circumstances, the invention has been made to solve the problems of the conventional art and has an object to provide a semiconductor device comprising a monitoring circuit capable of safely resetting a microcomputer in a decrease in a power, a monitoring circuit capable of setting a reset release section to be constant and the monitoring circuit, and furthermore, an electronic apparatus mounting the semiconductor device thereon.

A first aspect of the invention is directed to a monitoring circuit comprising a capacitor, charging means for charging the capacitor, discharging means for discharging the capacitor, voltage comparing means for comparing a certain reference voltage with a charging voltage of the capacitor, thereby generating a signal for resetting an operation of a monitoring object when the capacitor is charged to have a certain voltage or more, and source voltage deciding means for monitoring a source voltage of the monitoring object and resetting the operation of the monitoring object when the source voltage of the monitoring object is equal to or lower than a certain voltage.

A second aspect of the invention is directed to a monitoring circuit comprising a capacitor, charging means for charging the capacitor, first discharging means for discharging the capacitor, second discharging means for discharging the capacitor, voltage comparing means for comparing a certain reference voltage with a voltage of the capacitor, thereby generating a signal for resetting an operation of a monitoring object when the capacitor is charged to have a certain voltage or more, and source voltage deciding means for monitoring a source voltage of the monitoring object and resetting the operation of the monitoring object when the source voltage of the monitoring object is equal to or lower than a certain voltage.

A third aspect of the invention is directed to the monitoring circuit according to the first or second aspect of the invention, wherein the source voltage deciding means is constituted by a comparator and the charging means is constituted by a current source.

A fourth aspect of the invention is directed to the monitoring circuit according to the second or third aspect of the invention, wherein the first discharging means is constituted by a current source and the second discharging means is constituted by an analog switch, and either or both of the first and second discharging means is/are operated to invert an output of the voltage comparing means, thereby resetting the monitoring object when the source voltage of the monitoring object is equal to or lower than a certain voltage.

A fifth aspect of the invention is directed to the monitoring circuit according to the second or third aspect of the invention, wherein the first discharging means is constituted by a current source and the second discharging means is constituted by an N-type MOS transistor.

A sixth aspect of the invention is directed to the monitoring circuit according to any of the first to fifth aspects of the invention, wherein the voltage comparing means is constituted by a window comparator.

A seventh aspect of the invention is directed to the monitoring circuit according to any of the first to fifth aspects of the invention, wherein the voltage comparingmeansisconstituted byahysteresiscomparator.

An eighth aspect of the invention is directed to a semiconductor device comprising the monitoring circuit according to any of the first to seventh aspects of the invention.

A ninth aspect of the invention is directed to a semiconductor device comprising the monitoring circuit according to any of the first to seventh aspects of the invention in which the capacitor is provided on an outside of the semiconductor device.

A tenth aspect of the invention is directed to an electronic apparatus comprising the semiconductor device according to the eighth or ninth aspect of the invention and a microcomputer to be monitored by the semiconductor device.

As the advantages of the invention, the microcomputer can be reset safely also in a decrease in a power, a section for the reset release state of the microcomputer can be maintained to have a certain length and a reset signal can be generated in a desirable timing. Therefore, it is possible to eliminate a time loss caused before resetting the microcomputer. Furthermore, the control of the electronic apparatus comprising the microcomputer can be set to be more accurate.

### <BRIEF DESCRIPTION OF THE DRAWINGS>

Fig. 1 is a diagram showing a monitoring circuit according to a first embodiment of the invention.
Fig. 2 is a graph showing an operation state of the monitoring circuit illustrated in Fig. 1 ((a) indicates a source voltage 8b, (b) indicates a normal operation clock sent from a microcomputer 7, (c) indicates a reset signal sent from a comparator 5 and a window comparator 4 to the microcomputer 7 (reset with LOW), (d) indicates an amount of electric charges of a capacitor 3 which is measured by the window comparator 4, and (e) indicates an output of the window comparator 4).
Fig. 3 is a diagram showing a monitoring circuit according to a second embodiment of the invention.
Fig. 4 is a graph showing an operation state of the monitoring circuit illustrated in Fig. 3, and (a) indicates a source voltage 8b, (b) indicates a normal operation clock sent from a microcomputer 7, (c) indicates a rest signal sent from a comparator 5 and a window comparator 4 to the microcomputer 7 (reset with LOW), (d) indicates an amount of electric charges of a capacitor 3 which is measured by the window comparator 4, and (e) indicates an output of the window comparator 4.

For the designations in the drawings, 1 denotes a charging circuit, 2a denotes a constant current source, 2b denotes an N-type MOS transistor, 3 denotes a capacitor, 4 denotes a window comparator, 5 denotes a comparator, 6 and 9 denote a logic circuit, 7 denotes a microcomputer, 8a and 8b denote a source voltage, 10a, 10b and 10c denote a resistor, and 16 denotes a monitoring circuit.

### <BEST MODE FOR CARRYING OUT THE INVENTION>

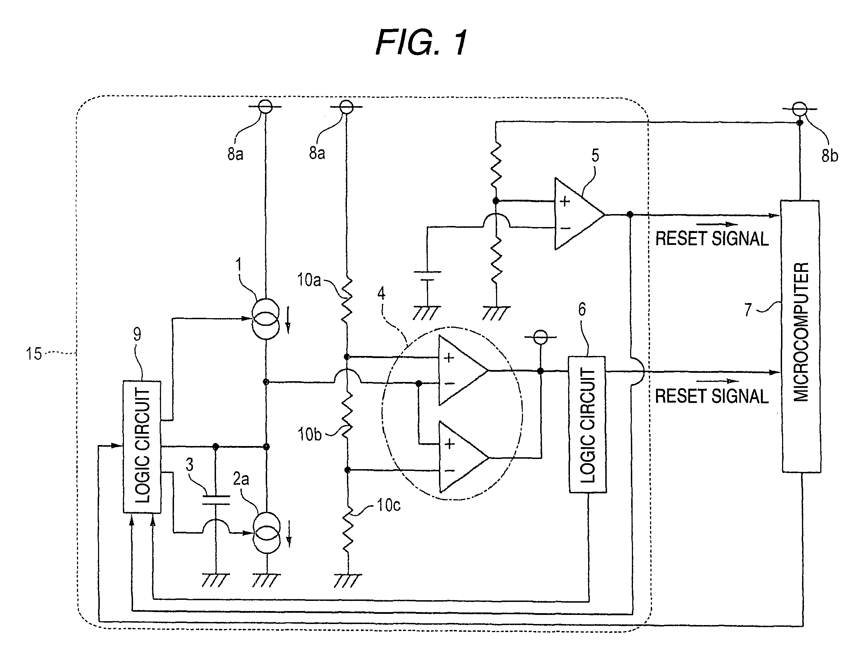

Fig. 1 shows a monitoring circuit 15 according to a structure of the invention. In Fig. 1, a current source 1 to be a charging circuit and a current source 2a to be a discharging circuit are connected to a capacitor 3, and the capacitor 3 is connected to an input terminal of a window comparator 4. For a threshold of the window comparator 4, an electric potential applied from a source voltage 8a is divided by resistors 10a, 10b and 10c and the voltages thus divided are set to be reference voltages. A logic circuit 6 is operated in order to/not to transmit a reset output of the window comparator 4 to a microcomputer 7. Furthermore, a source voltage of the microcomputer 7 is also monitored in a comparator 5, and at the same time, a reset signal is output from the comparator 5 to the microcomputer 7 in a decrease in an electricity of the microcomputer 7 and a trigger signal for discharging an electric charge of the capacitor 3 is transmitted to a logic circuit 9.

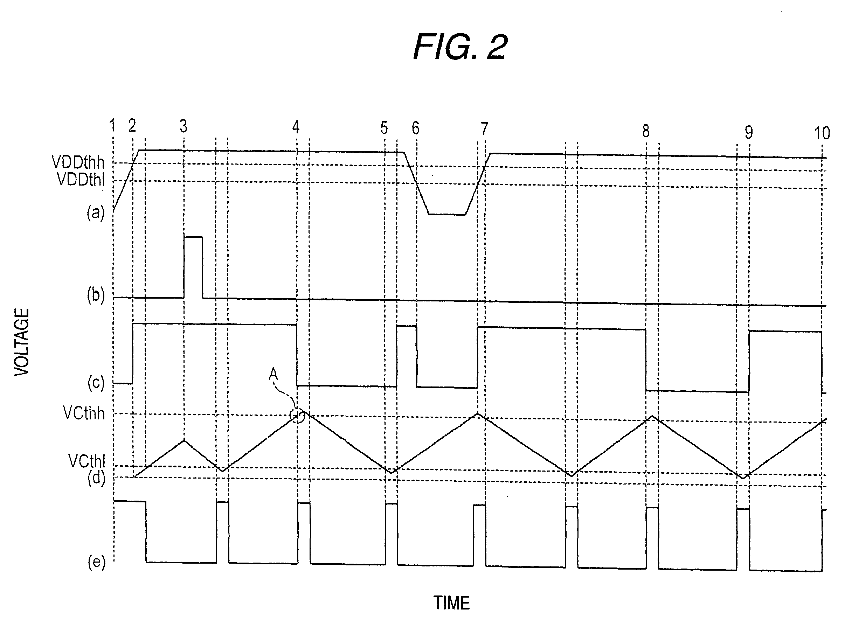

An operation of a monitoring circuit 15 will be described with reference to Fig. 2. In Fig. 2, an axis of ordinate indicates a voltage and an axis of abscissa indicates a time. In graphs of Fig. 2, (a) indicates a source voltage 8b, (b) indicates a normal operation clock sent from the microcomputer 7, (c) indicates a reset signal sent from the comparator 5 and the window comparator 4 to the microcomputer 7 (reset with LOW), (d) indicates an amount of electric charges of the capacitor 3 which is measured by the window comparator 4, and (e) indicates an output of the window comparator 4.

A vertical line (1) in Fig. 2 indicates a timing in which the monitoring circuit 15 and the microcomputer 7 according to the invention shown in Fig. 1 are turned on.

A vertical line (2) in Fig. 2 indicates a timing in which the source voltage 8b is higher than a threshold voltage (VDDthh) on the HIGH side of the comparator 5 so that the charging circuit 1 is activated to start to store electric charges in the capacitor 3. At this time, moreover, the microcomputer 7 is brought into a reset release state.

A vertical line (3) in Fig. 2 indicates a timing of an input of a normal operation clock from the microcomputer 7 which is to be input to the logic circuit 9 of the monitoring circuit 15 when the microcomputer 7 is operated normally. When the normal operation clock sent from the microcomputer 7 is input to the logic circuit 9, the charging circuit 1 is stopped so that the discharging circuit 2a is activated. Therefore, the electric charges of the capacitor 3 are discharged.

A vertical line (4) in Fig. 2 indicates a timing in which the electric charge of the capacitor 3 which is measured by the window comparator 4 is higher than a threshold voltage (VCthh) on the HIGH side of the window comparator 4. When the microcomputer 7 is not operated normally, the normal operation clock sent from the microcomputer 7 is not input to a logic circuit constituting a conventional monitoring circuit. Consequently, this state is brought. At this time, the output HIGH (H) of the window comparator 4 resets the microcomputer 7 through the logic circuit 6. Furthermore, the charging circuit 1 is stopped by the output H of the window comparator 4 and the charging circuit 2a is activated.

A vertical line (5) in Fig. 2 indicates a timing in which the electric charge of the capacitor 3 which is measured by the window comparator 4 is lower than a threshold voltage (VCthl) on the LOW side of the window comparator 4. At this time, the output of the window comparator 4 is HIGH so that the output of the window comparator 4 stops the discharging circuit 2a through the logic circuits 6 and 9 and the charging circuit 1 is activated.

A vertical line (6) in Fig. 2 indicates a timing in which the source voltage 8b is lower than a threshold voltage on the LOW side of the comparator 5 (a voltage VDDthl required for safely operating the microcomputer 7) for some reason. At this time, the microcomputer 7 is brought into a reset state in response to the output of the comparator 5.

As described above, the monitoring circuit 15 shown in Fig. 1 has such a structure that the microcomputer is reset when the source voltage is lower than the necessary voltage for the safe operation of the microcomputer, and the microcomputer is not decided to be operated normally and the microcomputer is thus reset when the normal operation clock sent from the microcomputer is not input to the monitoring circuit for a certain period.

According to the embodiment, it is possible to safely reset the microcomputer also in a decrease in a power of the microcomputer.

In the monitoring circuit 15 according to the invention shown in Fig. 1, a reset release section of the microcomputer 7 is varied in such a manner that lengths of a section between a vertical line (7) and a vertical line (8) and a section between a vertical line (9) and a vertical line (10) in Fig. 2 are different from each other. This is a phenomenon caused by constraints in respect of a structure of a circuit, that is, the microcomputer 7 is reset in response to the output of the window comparator 4 only when the electric charge of the capacitor 3 is higher than the threshold voltage on the HIGH side of the window comparator 4 in the case in which the source voltage 8b is continuously normal and in which the normal operation clock sent from the microcomputer 7 is not input to the monitoring circuit for a certain period as shown in a one-dotted chain line A in Fig. 2 illustrating a voltage waveform of the monitoring circuit 15 according to the invention in Fig. 1. More specifically, the reason why the different section is observed in the reset release section of the microcomputer 7 is that there is no means for resetting the microcomputer 7 other than the output of the window comparator 4 when the source voltage 8b is normal.

In order to measure a time that the normal operation clock to be output in the normal operation of the microcomputer 7 does not reach the monitoring circuit when the source voltage 8b is normal, however, it is necessary to employ a structure in which the microcomputer 7 is reset only when the electric charge of the capacitor 3 in the monitoring circuit shown in Fig. 1 is higher than the threshold voltage on the HIGH side of the window comparator 4 as shown in the one-dotted chain line A of Fig. 2.

In some cases in which the source voltage 8b is recovered and exceeds the threshold voltage on the HIGH side of the comparator 5 when the electric charge of the capacitor 3 is increased to some extent as shown in the vertical line (7) of Fig. 2, moreover, a signal for releasing the reset of the microcomputer 7 is output from the window comparator 4 or the logic circuit 6. As long as the source voltage is normal, the reset release signal is maintained in that state until the electric charge of the capacitor 3 exceeds the threshold voltage on the HIGH side of the window comparator 4.

From the foregoing, in the monitoring circuit 15 according to the invention shown in Fig. 1, there is made an imbalance that the different reset release section of the microcomputer 7 is generated in such a manner that the section between the vertical line (7) and the vertical cline (8) and the section between the vertical line (9) and the vertical line (10) in Fig. 2 have lengths which are different from each other.

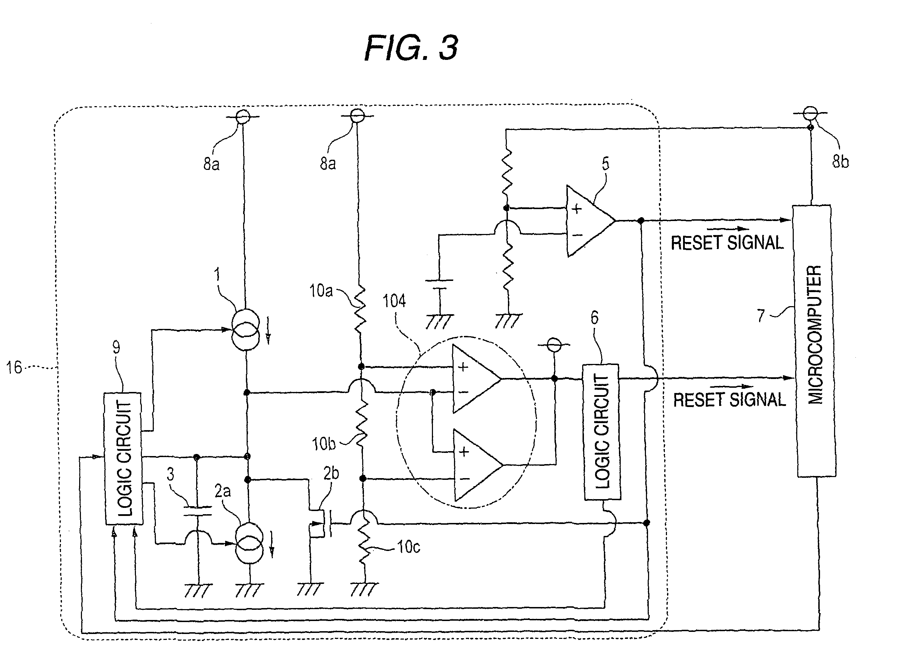

A monitoring circuit 16 shown in Fig. 3 according to a second embodiment of the invention serves to correct the unbalanced reset release section. In contrast to the monitoring circuit 15 shown in Fig. 1, the monitoring circuit according to the embodiment is provided with a discharging circuit 2b to be new discharging means and serves to discharge the electric charge of a capacitor 3 by a switching operation.

The monitoring circuit 16 according to the invention shown in Fig. 3 measures an arrival interval of a normal operation clock for monitoring a source voltage 8b (VDD) of a microcomputer 7 to be a monitoring object to safely end the microcomputer 7 in a decrease in a power in which the source voltage 8b is lower than a source voltage to safely operate the microcomputer 7 and for resetting the microcomputer 7 when a period for which the microcomputer 7 is not operated normally exceeds a certain period of time. The source voltage 8b of the microcomputer 7 is monitored by using a comparator 5 to be source voltage deciding means. Moreover, an interval between the normal operation clocks is monitored by controlling a charging circuit 1 to be charging means, and a discharging circuit 2a and a discharging circuit 2b which are discharging means to measure a voltage stored in the capacitor 3 through a window comparator 4 to be voltage comparing means, thereby creating a certain time to observe the arrival of the normal operation clock. Accordingly, the microcomputer 7 is not continuously operated without resetting in the decrease in a power but when the normal operation clock is input to the conventional monitoring circuit shown in Fig. 1. In Fig. 3, a source voltage 8a which is different from that of the microcomputer 7 is used for the source voltage of the monitoring circuit.

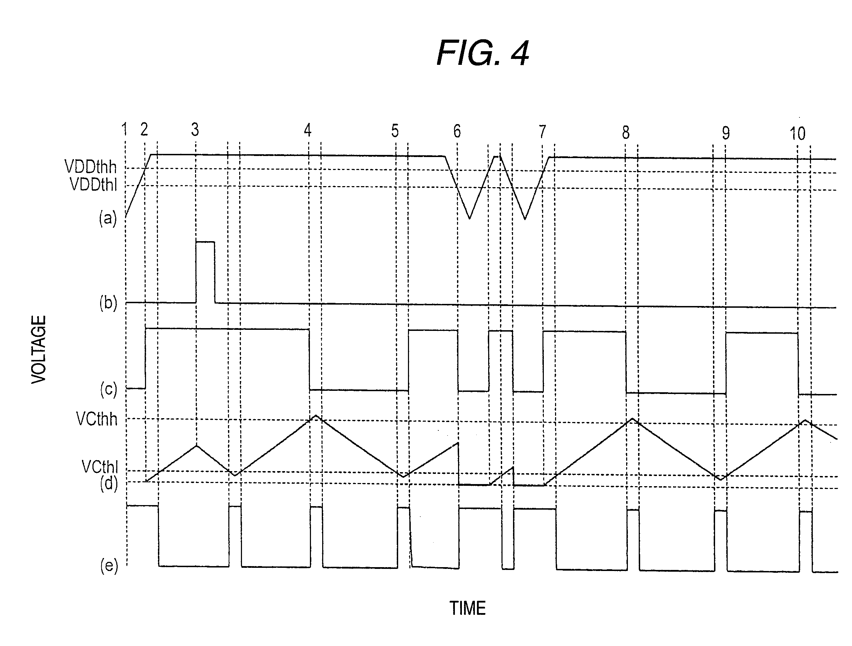

The operation of the monitoring circuit according to the invention shown in Fig. 3 will be described below with reference to a voltage fluctuation chart for the monitoring circuit according to the invention illustrated in Fig. 4. In Fig. 4, an axis of ordinate indicates a voltage and an axis of abscissa indicates a time. In graphs shown in Fig. 4, (a) indicates the source voltage 8b, (b) indicates a normal operation clock sent from the microcomputer 7, (c) indicates a reset signal sent from the comparator 5 to the microcomputer 7 (a reset state with LOW), (d) indicates an amount of electric charges of the capacitor 3 which is measured by the window comparator 4, and (e) indicates an output of the window comparator 4.

A vertical line (1) in Fig. 4 indicates a timing in which the conventional monitoring circuit and the microcomputer 7 shown in Fig. 3 are turned on.

A vertical line (2) in Fig. 4 indicates a timing in which the source voltage 8b is higher than a threshold voltage (VDDthh) on the HIGH side of the comparator 5 so that the charging circuit 1 is activated to start to store electric charges in the capacitor 3. At this time, moreover, the microcomputer 7 is brought into a reset releasestate. Although the threshold voltage on the HIGH side of the comparator 5 and a threshold voltage (VDDthl) on the LOW side of the comparator 5 which will be described below are set to have a hysteresis by feeding back the output of the comparator 5 to make a division through a resistor, this means is not restricted.

A vertical line (3) in Fig. 4 indicates a timing of an input of a normal operation clock from the microcomputer 7 which is to be input to a logic circuit 9 of the monitoring circuit according to the invention shown in Fig. 3 when the microcomputer 7 is operated normally. When the normal operation clock sent from the microcomputer 7 is input to the logic circuit 9, the charging circuit 1 is stopped so that the discharging circuit 2a is activated. Therefore, the electric charges of the capacitor 3 are discharged.

A vertical line (4) in Fig. 4 indicates a timing in which a charging voltage of the capacitor 3 which is measured by the window comparator 4 is higher than a threshold voltage (VCthh) on the HIGH side of the window comparator 4. If the normal operation clock sent from the microcomputer 7 is not input to the monitoring circuit according to the invention, this state is brought. At this time, the output HIGH (H) of the window comparator 4 resets the microcomputer 7 through a logic circuit 6. Furthermore, the charging circuit 1 is stopped by the output H of the window comparator 4 and the charging circuit 2a is activated. The threshold voltage on the HIGH side of the window comparator 4 and a threshold voltage (VCthl) on the LOW side of the window comparator 4 which will be described below are set by dividing a source voltage 8a of the window comparator 4 through resistors 10a, 10b and 10c, respectively.

A vertical line (5) in Fig. 4 indicates a timing in which the electric charge of the capacitor 3 which is measured by the window comparator 4 is lower than the threshold voltage (VCthl) on the LOW side of the window comparator 4. At this time, the discharging circuit 2a is stopped in response to the output of the window comparator 4, and furthermore, the charging circuit 1 is activated.

A vertical line (6) in Fig. 4 indicates a timing in which the source voltage 8b is lower than a threshold voltage (VDDthl) on the LOW side of the comparator 5 due to a fluctuation in a load or a noise. At this time, the microcomputer 7 is reset in response to the output of the comparator 5, and furthermore, thedischargingcircuit 2b is activated in response to the output of the comparator 5, thereby discharging the electric charge of the capacitor 3.

As described above, the monitoring circuit 16 according to the invention shown in Fig. 3 is operated in such a manner that the microcomputer 7 is reset in response to the output of the window comparator 4 when the electric charge of the capacitor 3 is stored and a voltage detected by the window comparator 4 is raised to exceed the threshold voltage on the HIGH side of the window comparator 4, and the microcomputer 7 is reset in response to the output of the comparator 5 when the source voltage 8b is lower than the threshold voltage on the LOW side of the comparator 5. More specifically, the monitoring circuit according to the invention serves to monitor both the interval between the normal operation clocks of the microcomputer 7 and the source voltage 8b of the microcomputer 7.

The monitoring circuit according to the invention has such a structure that the electric charge of the capacitor is discharged every time the source voltage of the monitoring object is reduced by a constant amount or more in a decrease in a power. In a voltage waveform diagram of Fig. 4 for the monitoring circuit according to the invention illustrated in Fig. 3, consequently, a reset release section between a vertical line (7) and a vertical line (8) is almost equal to a reset release section between a vertical line (9) and a vertical line (10) as compared with the voltage waveform diagram of Fig. 2 for the monitoring circuit 15 illustrated in Fig. 1. By maintaining the section of the reset release state of the microcomputer to have a constant length, it is possible to generate a reset signal in a desirable timing. Therefore, it is possible to eliminate a time loss before resetting the microcomputer. Furthermore, it is possible to cause the control of an electronic apparatus comprising the microcomputer to be more accurate.

While the invention has been described in detail with reference to the specific embodiments, it is apparent to the skilled in the art that various changes and modifications can be made without departing from the spirit and scope of the invention.

### <INDUSTRIAL APPLICABILITY>

The monitoring circuit according to the invention is sealed simply or together with other integrated circuits so as to be a semiconductor device, and the semiconductor device is mounted on an electronic apparatus together with a microcomputer to be a monitoring object. The electronic apparatus indicates every electric product comprising a microcomputer such as a television or a refrigerator.

The invention is not restricted to the embodiments but all designs and changes within the range of matters described in claims are included in the scope of the invention. For example, an analog switch may be used in place of the NMOS 2b. Even if a hysteresis comparator is used in place of the window comparator 4, it is possible to achieve the same object.

## Claims

1. A monitoring circuit comprising a capacitor, charging means for charging the capacitor, discharging means for discharging the capacitor, voltage comparing means for comparing a certain reference voltage with a charging voltage of the capacitor, thereby generating a signal for resetting an operation of a monitoring object when the capacitor is charged to have a certain voltage or more, and source voltage deciding means for monitoring a source voltage of the monitoring object and resetting the operation of the monitoring object when the source voltage of the monitoring object is equal to or lower than a certain voltage.

2. A monitoring circuit comprising a capacitor, charging means for charging the capacitor, first discharging means for discharging the capacitor, second discharging means for discharging the capacitor, voltage comparing means for comparing a certain reference voltage with a voltage of the capacitor, thereby generating a signal for resetting an operation of a monitoring object when the capacitor is charged to have a certain voltage or more, and source voltage deciding means for monitoring a source voltage of the monitoring object and resetting the operation of the monitoring object when the source voltage of the monitoring object is equal to or lower than a certain voltage.

3. The monitoring circuit according to claim 1 or 2, wherein the source voltage deciding means is constituted by a comparator and the charging means is constituted by a current source.

4. The monitoring circuit according to claim 2 or 3, wherein the first discharging means is constituted by a current source and the second discharging means is constituted by an analog switch, and either or both of the first and second discharging means is/are operated to invert an output of the voltage comparingmeans, thereby resetting the monitoring object when the source voltage of the monitoring obj ect is equal to or lower than a certain voltage.

5. The monitoring circuit according to claim 2 or 3, wherein the first discharging means is constituted by a current source and the second discharging means is constituted by an N-type MOS transistor.

6. The monitoring circuit according to claim 1 or 2, wherein the voltage comparing means is constituted by a window comparator.

7. The monitoring circuit according to claim 1 or 2, wherein the voltage comparing means is constituted by a hysteresis comparator.

8. A semiconductor device comprising the monitoring circuit according to claim 1 or 2 in which the capacitor is provided on an outside of the semiconductor device.
